(19)

Europäisches
Patentamt
European
Patent Office
Office européen
des brevets

(11) **EP 2 237 322 A2**

(12) **EUROPEAN PATENT APPLICATION**

(43) Date of publication:
06.10.2010 Bulletin 2010/40

(51) Int Cl.:
*H01L 31/0296* (2006.01)    *H01L 31/0352* (2006.01)
*H01L 31/0368* (2006.01)    *H01L 31/18* (2006.01)

(21) Application number: 10157078.6

(22) Date of filing: 19.03.2010

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA ME RS

(30) Priority: 31.03.2009 US 415275

(71) Applicant: General Electric Company
Schenectady, NY 12345 (US)

(72) Inventors:
• Korevaar, Bastiaan Arie
  Schenectady, NY 12305 (US)

• Johnson, James Neil
  Scotia, NY 12302 (US)
• Zhong, Dalong
  Niskayuna, NY 12309 (US)
• Xi, Yangang Andrew
  Schenectady, NY 12308 (US)
• Ahmad, Faisal Razi
  Niskayuna, NY 12309 (US)

(74) Representative: Bedford, Grant Richard
Global Patent Operation - Europe
GE International Inc.
15 John Adam Street
London WC2N 6LU (GB)

(54) **Layer for thin film photovoltaics and a solar cell made therefrom**

(57)    A photovoltaic device 100 is provided comprising an absorber layer 416, wherein the absorber layer comprises a plurality of grains separated by grain boundaries. At least one layer is disposed over the absorber layer. The absorber layer 416 comprises grain boundaries that are substantially perpendicular to the at least one layer disposed over the absorber layer. The plurality of grains 412 has a median grain diameter of less than 1 micrometer. Further, the grains are either p-type or n-type. The grain boundaries comprise an active dopant. The active dopant concentration in the grain boundaries is higher than the effective dopant concentration in the grains. The grains 412 and grain boundaries may be of the same type or opposite type. Further, when the grain boundaries are n-type the bottom of the grain boundaries may be p-type. A method of making the absorber layer 416 is also disclosed.

FIG. 2

EP 2 237 322 A2

**Description**

The invention relates generally to the field of photovoltaics. In particular, the invention relates to a layer used in solar cells and a solar cell made therefrom.

Solar energy is abundant in many parts of the world year around. Unfortunately, the available solar energy is not generally used efficiently to produce electricity. The cost of conventional solar cells, and electricity generated by these cells, is generally very high. For example, a typical solar cell achieves a conversion efficiency of less than 20 percent. Moreover, solar cells typically include multiple layers formed on a substrate, and thus solar cell manufacturing typically requires a significant number of processing steps. As a result, the high number of processing steps, layers, interfaces, and complexity increase the amount of time and money required to manufacture these solar cells.

Accordingly, there remains a need for an improved solution to the long-standing problem of inefficient and complicated solar energy conversion devices and methods of manufacture.

In one embodiment, a photovoltaic device is provided. The device comprises an absorber layer, wherein the absorber layer comprises a plurality of grains separated by grain boundaries. At least one layer is disposed over the absorber layer. The absorber layer comprises grain boundaries that are substantially perpendicular to the layer. The plurality of grains has a median grain diameter of less than 1 micrometer.

Another embodiment is a photovoltaic device. The device comprises an absorber layer, wherein the absorber layer comprises a plurality of grains separated by grain boundaries. At least one layer is disposed over the absorber layer. The absorber layer comprises grain boundaries that are substantially perpendicular to the layer. The grain boundaries comprise an active dopant; and wherein the active dopant concentration in the grain boundaries is higher than the effective dopant concentration in the grains.

Another embodiment is a photovoltaic device. The device comprises an absorber layer, wherein the absorber layer comprises a plurality of grains separated by grain boundaries. At least one layer is disposed over the absorber layer. The absorber layer comprises grain boundaries that are substantially perpendicular to the layer. The grain boundaries comprise an active dopant; wherein the amount of the active dopant in the grain boundaries is sufficient to make the grain boundaries a type opposite to that of the type of the grains in the layer. The amount of the active dopant in the grain boundaries near the bottom region of the layer is sufficient to allow the grain boundaries in the bottom region to remain of a type similar to the type of the grains while simultaneously having a higher active dopant concentration in the grain boundaries when compared to the effective dopant concentration in the grains.

Another embodiment is a method. The method comprises providing an absorber layer in a photovoltaic device, wherein the absorber layer comprises a plurality of grains separated by grain boundaries. At least one layer is disposed over the absorber layer. The absorber layer comprises grain boundaries that are substantially perpendicular to the layer. The plurality of grains has a median grain diameter of less than 1 micrometer.

Another embodiment is a method. The method comprises providing an absorber layer in a photovoltaic device, wherein the absorber layer comprises a plurality of grains separated by grain boundaries. At least one layer is disposed over the absorber layer. The absorber layer comprises grain boundaries that are substantially perpendicular to the layer. The grain boundaries comprise an active dopant. The active dopant concentration in the grain boundaries is higher than the effective dopant concentration in the grains.

Various features, aspects, and advantages of the present invention will become better understood when the following detailed description is read with reference to the accompanying drawings in which like characters represent like parts throughout the drawings, wherein:

FIG. 1 illustrates a schematic of a photovoltaic device;

FIG. 2 illustrates a layer of a photovoltaic device in accordance with certain embodiments of the present invention;

FIG. 3 illustrates a layer of a photovoltaic device in accordance with certain embodiments of the present invention;

FIG. 4 illustrates a layer of a photovoltaic device in accordance with certain embodiments of the present invention;

FIG. 5 illustrates a layer of a photovoltaic device in accordance with certain embodiments of the present invention;

FIG. 6 illustrates a layer of a photovoltaic device in accordance with certain embodiments of the present invention;

FIG. 7 illustrates a schematic of a method to make a layer of a photovoltaic device as shown in FIG. 2 in accordance with certain embodiments of the present invention; and

FIG. 8 illustrates a schematic of a method to make a layer of a photovoltaic device as shown in FIG. 6 in accordance with certain embodiments of the present invention.

Cadmium telluride (CdTe) based solar devices known in the art typically demonstrate relatively low power conversion efficiencies, which may be attributed to a relatively low open circuit voltage ($V_{oc}$) in relation to the bandgap of the material. This is due to the fact that the effective carrier concentration in CdTe is generally quite low. Traditionally, the performance of a CdTe based device has been explained by attributing bulk-properties to the CdTe. However, there are increasing indications that the device performance is primarily controlled by the properties of the grain boundaries, and thus bulk-properties only present an effective collective value of the whole film forming the solar cell.

Various embodiments of the invention described herein address the noted shortcomings of the state of the art. The device includes substantially columnar grains in at least one layer of the device, wherein the grain boundaries in the layer are substantially perpendicular to an adjacent layer. In certain embodiments, the columnar grains stretching from the front to the backside of the device or a layer of the device layer may result in the charge carriers moving smoothly without having to traverse the grain boundaries, which act either as barriers or recombination centers, typically resulting in a reduction in the fill factor of the device. Further, a doping method is also described that permits the addition of active dopants to the substantially perpendicular grain boundaries; the method may result in the formation of a layer with controlled grain boundary doping and hence higher $V_{oc}$ and improved device efficiency. Appreciating that these doped layers actually act as mini-junctions all through the film, with the junctions being formed between the grain boundaries and their adjacent grains, changes the concept of improving performance of these devices. In one embodiment, by appropriately doping the grain boundaries, one type of carrier can be transported along the grain boundary, while the other type of carrier can be transported through the grain. Also, as discussed, by independently controlling the quality of the grains and grain boundaries (i.e., the effective dopant concentrations of those regions), one can increase the open-circuit voltage of these types of photovoltaic devices.

One or more specific embodiments of the present invention will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present invention, the articles "a," "an," "the," and "said" are intended to mean that there are one or more of the elements. The terms "comprising," "including," and "having" are intended to be inclusive and mean that there may be additional elements other than the listed elements. Moreover, the use of "top," "bottom," "above," "below," and variations of these terms is made for convenience, but does not require any particular orientation of the components unless otherwise stated. As used herein, the terms "disposed over" or "deposited over" or "disposed between" refers to both secured or disposed directly in contact with and indirectly by having intervening layers therebetween.

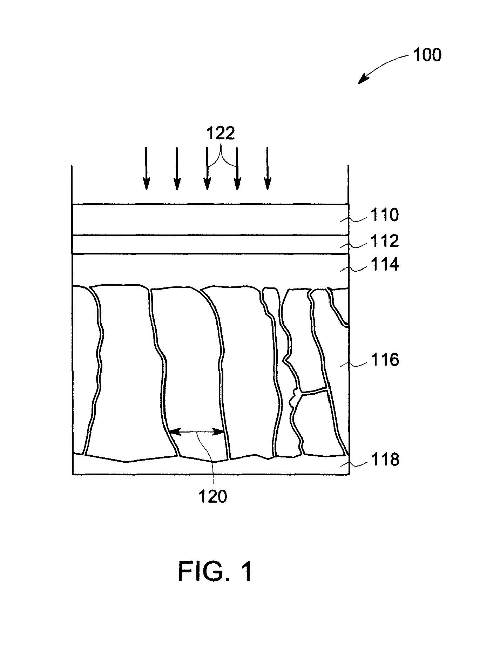

As illustrated in FIG. 1, in one embodiment, a photovoltaic device 100 is provided. The device comprises a plurality of layers 110, 112, 114, 116 and 118. At least one layer comprises a semiconducting material with a plurality of grains separated by grain boundaries, wherein the grains are either p-type or n-type. The grain boundaries are substantially perpendicular to an adjacent layer. The plurality of grains has a median grain diameter of less than 1 micrometer.

As used herein the phrase "median grain diameter" means the median spacing between a population of grain boundaries, which themselves are substantially perpendicular to the adjacent layers. In one embodiment, the grains are elongated (i.e., having one dimension longer than another dimension). In one embodiment, the grains are columnar, wherein the median grain diameter is the width (short axis) of the elongated or columnar grains, as opposed to the height (long axis) of the grains. In one embodiment, the plurality of grains has a median grain diameter of less than or equal to 0.95 micrometer. In another embodiment, the plurality of grains has a median grain diameter of less than or equal to 800 nanometers. In yet another embodiment, the plurality of grains has a median grain diameter of less than or equal to 500 nanometers.

As used herein, the phrase "substantially perpendicular" to a reference layer means that the grain boundaries, taken as a population, form a median angle in the range from about 60 degrees to about 120 degrees with an interface between the layer containing the grain boundaries and the reference layer. In some embodiments, this median angle is in the range from about 80 degrees to about 100 degrees. In particular embodiments, this angle is about 90 degrees.

In one embodiment, the layer is an absorber layer 116. Typically, when light falls on the solar cell 100, electrons in the absorber layer 116 are excited from a lower energy "ground state," in which they are bound to specific atoms in the solid, to a higher "excited state," in which they can move through the solid. Since most of the energy in sunlight and artificial light is in the visible range of electromagnetic radiation, a solar cell absorber should be efficient in absorbing radiation at those wavelengths. In one embodiment, the grains of the absorber layer 116 may be perpendicular to the adjacent window layer 114. In one embodiment, the grains of the absorber layer 116 may be perpendicular to the adjacent back contact layer 118.

In one embodiment, the absorber layer 116 comprises cadmium telluride, cadmium zinc telluride, cadmium sulfur telluride, cadmium manganese telluride, or cadmium magnesium telluride. CdTe is a prominent polycrystalline thin-film material, with a nearly ideal bandgap of about 1.45 electron volts to about 1.5 electron volts. CdTe also has a very high absorptivity. Although CdTe is most often used in photovoltaic devices without being alloyed, it can be alloyed with zinc, magnesium, manganese, and a few other elements to vary its electronic and optical properties. Films of CdTe can be manufactured using low-cost techniques. In one embodiment, the CdTe absorber layer 116 may typically comprise grain boundaries that are substantially perpendicular to the adjacent window layer 114 and back contact layer 118.

The cadmium telluride may, in certain embodiments, comprise other elements from the Group II and Group VI or Group III and Group V that may not result in large bandgap shifts. In one embodiment, the bandgap shift is less than or equal to about 0.1 electron Volts for the absorber layer. In one embodiment, the atomic percent of cadmium in the cadmium telluride is in a range from about 48 atomic percent to about 52 atomic percent. In one embodiment, the atomic percent of tellurium in the cadmium telluride is in range from about 45 atomic percent to about 55 atomic percent. In one embodiment, the cadmium telluride employed may include a tellurium-rich cadmium telluride. In one embodiment, the atomic percent of tellurium in the tellurium-rich cadmium telluride is in range from about 52 atomic percent to about 55 atomic percent. In one embodiment, the atomic percent of zinc or magnesium in cadmium telluride is less than about 10 atomic percent. In another embodiment, the atomic percent of zinc or magnesium in cadmium telluride is about 8 atomic percent. In yet another embodiment, the atomic percent of zinc or magnesium in cadmium telluride is about 6 atomic percent. In one embodiment, the CdTe absorber layer 116 may typically comprise grain boundaries that are substantially perpendicular to the adjacent window layer 114 and back contact layer 118.

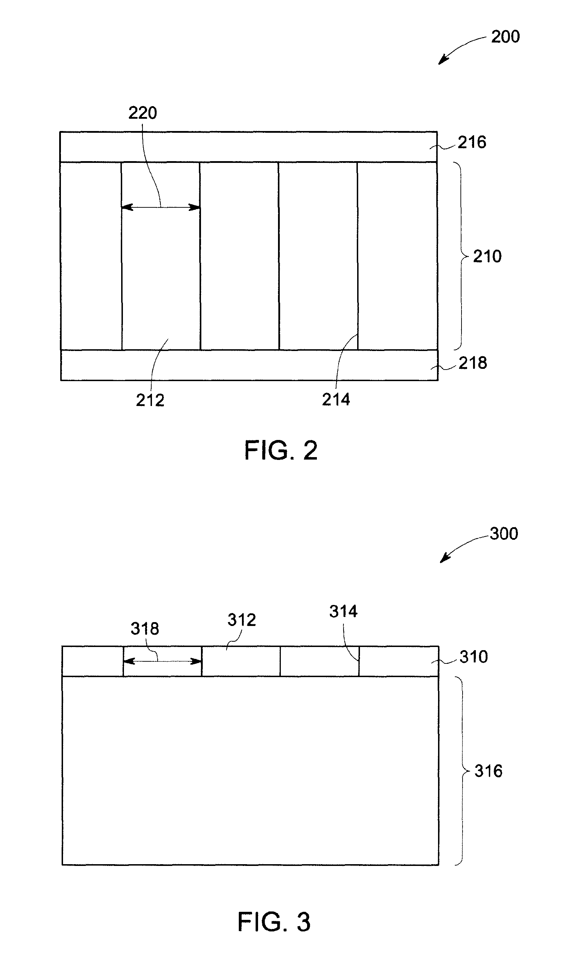

Another embodiment is a photovoltaic device. The device comprises an absorber layer. The absorber layer comprises a plurality of grains separated by grain boundaries. At least one layer is disposed over the absorber layer. The absorber layer comprises grain boundaries that are substantially perpendicular to the layer. The plurality of grains has a median grain diameter of less than 1 micrometer. Referring to FIG. 2, a layer 200 of a photovoltaic device in accordance with certain embodiments of the present invention is illustrated. In the embodiment described in FIG. 2, the layer may comprise an absorber layer 210 formed using CdTe. The absorber layer includes a plurality of grains 212 and grain boundaries 214. The grain boundaries 214 are substantially perpendicular to an adjacent window layer 216 and an adjacent back contact layer 218. The plurality of grains has a median grain diameter 220 of less than 1 micrometer. The window layer 216 may be formed using cadmium sulfide (CdS), for example. The back contact layer 218 may be formed using copper telluride, for example.

In one embodiment, the layer with grain boundaries substantially perpendicular to an adjacent layer is a window layer 114. The window layer 114, disposed on absorber layer 116, is the junction-forming layer for device 100. The "free" electrons in the absorber layer 116 are in random motion, and so generally there can be no oriented direct current. The addition of the window layer 114, however, induces a built-in electric field that produces the photovoltaic effect. Referring to FIG. 3, a layer 300 of a photovoltaic device in accordance with certain embodiments of the present invention is illustrated. In the embodiment illustrated in FIG. 3, the layer may comprise a window layer 310 formed using CdS. The window layer includes a plurality of grains 312 and grain boundaries 314. The grain boundaries 314 are substantially perpendicular to the adjacent absorber layer 316. The plurality of grains has a median grain diameter 318 of less than 1 micrometer. The absorber layer 316 may be formed using CdTe. Materials suitable for use in the window layer 114 include, for example, cadmium sulfide, zinc telluride, zinc selenide, cadmium selenide, cadmium sulfur oxide, copper oxide, or a combination thereof. The atomic percent of cadmium in the cadmium sulfide, in some embodiments, is in range from about 48 atomic percent to about 52 atomic percent. In one embodiment, the atomic percent of sulfur in the cadmium sulfide is in a range from about 45 atomic percent to about 55 atomic percent.

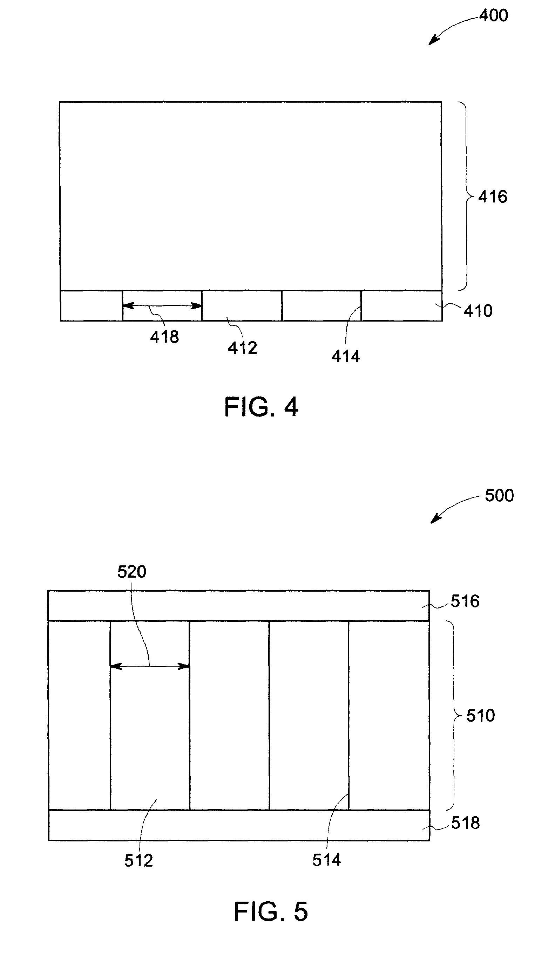

In one embodiment, the layer with grain boundaries substantially perpendicular to an adjacent layer is a back contact layer 118, which transfers current into or out of device 100, depending on the overall system configuration. Generally, back contact layer 118 comprises a metal, a semiconductor, other appropriately electrically conductive material, or combinations of such materials. Referring to FIG. 4, a layer 400 of a photovoltaic device in accordance with certain embodiments of the present invention is illustrated. In the embodiment illustrated in FIG. 4, the layer may comprise a back contact layer 410 formed using copper. The back contact layer includes a plurality of grains 412 and grain boundaries 414. The grain boundaries 414 are substantially perpendicular to the adjacent absorber layer 416. The plurality of grains has a median grain diameter 418 of less than 1 micrometer. The absorber layer 416 may be formed using CdTe. In some embodiments, the back contact layer may comprise one or more of a semiconductor selected from zinc telluride (ZnTe), mercury telluride (HgTe), cadmium mercury telluride (CdHgTe), arsenic telluride ($As_2Te_3$), antimony telluride ($Sb_2Te_3$), and copper telluride ($Cu_xTe$).

Another embodiment is a photovoltaic device 100. The device comprises a plurality of layers 110, 112, 114, 116, 118, and 122. At least one layer 116 comprises a plurality of grains separated by grain boundaries, wherein the grain boundaries are substantially perpendicular to an adjacent layer 114. The grain boundaries comprise an active dopant. The active dopant concentration in the grain boundaries is higher than the effective dopant concentration in the grains. As used herein the term "active dopant" means that the dopant employed comprises a foreign material different from the material comprising the grains. The foreign material may be considered as impurities willfully introduced in the grain boundaries. A person skilled in the art will appreciate that grains contain inherent manufacturing defects at the grain boundaries and these defects in the grain boundaries may also function as dopants. However, in the context of the current disclosure, these defects are not considered "active dopants."

As mentioned above, the active dopant, i.e., the foreign material, is added in the grain boundaries to actively dope the grain boundaries. The active dopants in a layer render the grain boundaries either p-type or n-type. As used herein the phrase "active dopant concentration" means the resultant doping concentration of a layer based on both the acceptor states and the donor states that are present in the layer on account of various types of defects and willfully introduced impurities present in the layer. In one embodiment, the defects are inherent in the layers based on the method of manufacturing while the impurities may be introduced in the layers during the manufacturing process as discussed herein. Also, as used herein the phrase "effective dopant concentration" means the resultant doping concentration of a layer based on both the acceptor states and the donor states that are present in a layer on account of various types of defects present in the layer.

In one embodiment, the active dopant concentration in the grain boundaries is sufficient to make the grain boundaries a type opposite to that of the type of the grains in the layer. In one embodiment, the grains are p-type and the grain boundaries are n-type. In another embodiment, the grains are n-type and the grain boundaries are p-type. Alternatively, in some embodiments the grains and grain boundaries are of the same type (p or n).

In certain embodiments, the absorber layer 116 comprises p-type grains and n-type grain boundaries. In another embodiment, the absorber layer 116 comprises n-type grains and p-type grain boundaries. In certain other embodiments, the absorber layer 116 comprises grains and grain boundaries of the same type. Referring to FIG. 2, a layer 200 of a photovoltaic device in accordance with certain embodiments of the present invention is illustrated. In the embodiment illustrated in FIG. 2, the layer may comprise an absorber layer 210 formed using CdTe. The absorber layer 210, in some embodiments, includes a plurality of p-type grains 212 and n-type grain boundaries 214. The grain boundaries 214 are substantially perpendicular to the adjacent window layer 216 and the adjacent back contact layer 218. The plurality of grains, in some embodiments, has a median grain diameter 220 of less than 1 micrometer. The window layer 216 may be formed using CdS, for example. The back contact layer 218 may be formed using copper, for example. In certain embodiments, the absorber layer 210 includes a plurality of n-type grains 212 and p-type grain boundaries 214. In certain other embodiments, the absorber layer 210 includes a plurality of n-type grains 212 and p-type grain boundaries 214, or a plurality of p-type grains 212 and p-type grain boundaries 214.

In certain embodiments, referring to FIG. 3, window layer 310 comprises n-type grains 312 and n-type grain boundaries 314. As mentioned above, the n-type grain boundaries 314 are substantially perpendicular to the adjacent absorber layer 316. The n-type doped grain boundaries of the window layer may assist in electron transport to the contact on top of the window layer. Further the columnar grains in the window layer stretching from the front to the backside of the window layer may result in the n-type charge carriers moving smoothly without having to traverse the grain boundaries, which act either as barriers or recombination centers.

In particular embodiments, absorber layer 116, as illustrated in FIG. 1, comprises cadmium telluride and window layer 114 comprises cadmium sulfide, thereby providing a heterojunction interface between the two layers. In certain embodiments the window layer 114 acts as an n-type window layer that forms the pn-junction with the p-type absorber layer.

In one embodiment, referring to FIG. 4, the back contact layer 410 comprises p-type grains 412 and p-type grain boundaries 414. As mentioned above, the p-type grain boundaries 414 are substantially perpendicular to the adjacent absorber layer 416. The p-type grain boundaries will assist in transporting the charge carriers between the back contact layer 410 and the absorber layer 416. Further the columnar grains in the back contact layer 410 stretching from the front to the backside of the back contact layer may result in the p-type charge carriers moving smoothly without having to traverse the grain boundaries, which act either as barriers or recombination centers.

In one embodiment, as illustrated in FIG. 1, the photovoltaic device 100 further comprises a substrate 110, a front contact layer 112 disposed over the substrate 110, and a metal layer 122 disposed on the back contact layer. In the illustrated embodiment, a window layer 114 is disposed over the front contact layer 112. An absorber layer 116 is disposed over the window layer 114. The window layer 114 comprises a material of the opposite semiconductor type relative to the semiconductor type of the absorber layer. A back contact layer 118 is disposed over the absorber layer and finally a metal layer 122 is disposed over the back contact layer.

The configuration of the layers illustrated in FIG. 1 may be referred to as a "superstrate" configuration because the light 120 enters from the substrate 110 and then passes on into the device. Since, in this embodiment, the substrate layer 110 is in contact with the front contact layer 112, the substrate layer 110 is generally sufficiently transparent for visible light to pass through the substrate layer 110 and come in contact with the front contact layer 112. Suitable examples of materials used for the substrate layer 110 in the illustrated configuration include glass or a polymer. In one embodiment, the polymer comprises a transparent polycarbonate or a polyimide. The front and the back contact layers are needed to carry the electric current out to an external load and back into the device, thus completing an electric circuit.

In one embodiment, the front contact layer 112 comprises a transparent conductive oxide, examples of which include cadmium tin oxide ($Cd_2SnO_4$), zinc tin oxide ($ZnSnO_x$), indium tin oxide (ITO), aluminum-doped zinc oxide (ZnO:Al), zinc oxide (ZnO), and/or fluorine-doped tin oxide (SnO:F) and combinations of these. In some embodiments, the metal layer may comprise one or more of group IB metal, or a group IIIA metal, or a combination thereof. Suitable non-limiting examples of group IB metals include copper (Cu), silver (Ag), and gold (Au). Suitable non-limiting examples of group IIIA metals (e.g., the low melting metals) include indium (In), gallium (Ga), and aluminum (Al). Other examples of potentially suitable metals include molybdenum and nickel. In various embodiments, the window layer 114, the absorber layer 116, and the back contact layer 118 respectively comprise one or more of the materials previously described for these components. In one embodiment, the device 100 illustrated in FIG. 1 is a CdTe solar cell. In CdTe solar cells the light enters through the substrate 110 on the front-side (for example, glass), passes through the front contact layer 112 (for example, a transparent conductive oxide (SnO:F)) and the window layer 114 (for example, CdS) to be absorbed by the absorber layer 116 (for example, CdTe), where the light generates electron-hole pairs. Typically the window layer 114 acts as an n-type window layer that forms the pn-junction with the p-type absorber layer.

In an alternative embodiment, a "substrate" configuration comprises a photovoltaic device wherein a back contact layer is disposed on a substrate layer. Further an absorber layer is disposed over the back contact layer. A window layer is then disposed on the absorber layer and a front contact layer is disposed on the window layer. In the substrate configuration, the substrate layer may comprise glass, polymer, or a metal foil. In one embodiment, metals that may be employed to form the metal foil include stainless steel, molybdenum, titanium, and aluminum.

As mentioned above, in one embodiment, the grain boundaries of the layer material are n-type. Suitable active dopants employed to make n-type grain boundaries of CdTe, include a material selected from aluminum, gallium, indium, iodine, chlorine, and bromine. As mentioned above, in one embodiment, the grain boundaries of the layer material are p-type; for example, CdTe can be formed both as an n-type and a p-type semiconductor. Suitable active dopants employed to make p-type grain boundaries include copper, gold, silver, sodium, bismuth, sulfur, arsenic, phosphorous, and nitrogen.

As mentioned above, the active dopant concentration in the grain boundaries is higher than the effective dopant concentration in the grains. In one embodiment, the effective active dopant concentration in the grain boundaries is in a range from about $5 \times 10^{16}$ per cubic centimeter to about $10^{19}$ per cubic centimeter. In another embodiment, active dopant concentration in the grain boundaries is in a range from about $5 \times 10^{15}$ per cubic centimeter to about $10^{18}$ per cubic centimeter. In yet another embodiment, active dopant concentration in the grain boundaries is in a range from about $10^{15}$ per cubic centimeter to about $5 \times 10^{17}$ per cubic centimeter. In one embodiment, the effective dopant concentration in the grains is in a range from about $10^{16}$ per cubic centimeter to about $10^{18}$ per cubic centimeter. In another embodiment, the effective dopant concentration in the grains is in a range from about $10^{15}$ per cubic centimeter to about $10^{17}$ per cubic centimeter. In yet another embodiment, the effective dopant concentration in the grains is in a range from about $5 \times 10^{14}$ per cubic centimeter to about $5 \times 10^{16}$ per cubic centimeter.

Another embodiment is a photovoltaic device. The device comprises a plurality of layers. At least one layer comprises a plurality of grains separated by grain boundaries, wherein the grain boundaries are substantially perpendicular to an adjacent layer. The grain boundaries comprise an active dopant. The active dopant concentration in the grain boundaries is higher than the effective dopant concentration in the grains. Further, in one embodiment, the plurality of grains has a median diameter of less than 1 micrometer. Referring to FIG. 5, a layer 500 of a photovoltaic device in accordance with certain embodiments of the present invention is illustrated. In the embodiment described in FIG. 5, the layer may comprise an absorber layer 510 formed using CdTe. The absorber layer 510 includes a plurality of grains 512 separated by grain boundaries 514, wherein the grain boundaries 514 are substantially perpendicular to an adjacent window layer 516 and an adjacent back contact layer 518. The grain boundaries 514 include an active dopant such that the active dopant concentration in the grain boundaries is higher than the effective dopant concentration in the grains 512. The plurality of grains has a median diameter 520 of less than 1 micrometer. As discussed above, in one embodiment, the active dopant concentration in the grain boundaries is sufficient to make the grain boundaries an opposite type or a same type to that of the type of the grains in the layer.

Another embodiment is a photovoltaic device 600. The device comprises a plurality of layers 610, 618, and 620, wherein at least one layer 610 comprises a plurality of grains 612 separated by grain boundaries 614. The grain boundaries 614 are substantially perpendicular to adjacent layers 618 and 620. The grain boundaries 614 comprise an active dopant; wherein the amount of the active dopant in the grain boundaries is sufficient to make the grain boundaries a type opposite to that of the type of the grains in the layer; and wherein the amount of the active dopant in the grain boundaries near the bottom region 616 of the layer is sufficient to allow the grain boundaries in the bottom region to remain of a type similar to the type of the grains while simultaneously having a higher active dopant concentration in the grain boundaries 614 when compared to a effective dopant concentration in the grains 612. In one embodiment, the layer 610 is an absorber layer having p-type grains 612 and n-type grain boundaries 614 with p-type bottom region 616. The grain boundaries 614 are substantially perpendicular to the adjacent window layer 618 and the adjacent back contact layer 620.

In certain embodiments, the doping concentration along the grain boundary from top to bottom is graded from high concentration of one type, for example n-type, on the top, to a high concentration of opposite type, for example p-type, on the bottom. In another embodiment the effective dopant concentration along the grain boundaries is graded from one type to the other type when going from one side of the layer to the other side of the layer. When making devices in which the active dopants are driven into the layer from both sides of the layer, the region where the active dopants of opposite type come in contact, might result in an effectively graded region. When incorporating the active dopants along the grain boundaries, active dopants of the opposite type can cancel out the effect of each other, which is a kind of self-compensation, resulting in an effective lower dopant concentration. One skilled in the art will appreciate that though the active dopant concentration in a certain region can be higher than in a certain another region, the effective dopant concentration can be lower.

Yet another embodiment is a method for making the devices described above. The method comprises providing a layer such as one or more of layers 110, 112, 114, 116, and 118 in a photovoltaic device 100. The layer comprises a semiconducting material comprising a plurality of grains separated by grain boundaries wherein the grain boundaries are substantially perpendicular to an adjacent layer. The grains are either p-type or n-type. In certain embodiments, the grain boundaries may comprise an active dopant. The active dopant concentration in the grain boundaries is higher than the effective dopant concentration in the grains. The plurality of grains has a median grain diameter of less than 1 micrometer.

In one embodiment, the grains may be deposited using one or more techniques selected from close-space sublimation, vapor transport deposition, ion-assisted physical vapor deposition, radio frequency or pulsed magnetron sputtering, chemical vapor deposition and electrochemical bath deposition. In certain embodiments, columnar grains of CdTe can be grown using the various deposition techniques listed above. In certain embodiments, by employing ion-assisted physical vapor deposition, radio frequency or pulsed magnetron sputtering, and electrochemical bath deposition techniques the column size can to some extent be controlled by either varying the chemical bath potential, ion energy, pulse duration and frequency, deposition source temperature, substrate temperature and growth rate during deposition.

Another embodiment is a method. The method comprises providing a plurality of layers, wherein at least one layer comprises a plurality of grains separated by grain boundaries, wherein the grain boundaries are substantially perpendicular to an adjacent layer; wherein the grain boundaries comprise an active dopant; and wherein the active dopant concentration in the grain boundaries is higher than the effective dopant concentration in the grains.

In one embodiment, the method comprises providing an active dopant, and treating the at least one layer in a manner such that the active dopant is diffused into the grain boundaries and remains confined therein. In various embodiments, the diffusion of the active dopant into the grain boundaries may be achieved using methods known to one skilled in the art.

For example, a CdTe device may be made using a wide variety of methods including closed-space sublimation, electro chemical deposition, chemical bath deposition, vapor transport deposition, and other physical or chemical vapor deposition. In one embodiment, the diffusion of dopants from grains into grain boundaries may be achieved by applying a film of the active dopant on the surface of the layer to be doped. The film may contain a controlled concentration of the active dopant. The layer with the film may then be heat treated for incorporating the doping substance into the crystal lattice positions in the layer. For example, in one embodiment, a thin metallic film containing the active dopant may be deposited on the backside of a CdTe device, after CdTe deposition. On heating the sample to a temperature of about 400 degrees Celsius, the active dopants diffuse along the grain boundaries, passivating and actively doping defects within the grain boundaries.

In another embodiment, the active dopants may be deposited within a thin film on top of the CdS layer, before the deposition of CdTe over the CdS layer. During the deposition of the CdTe film, typically at high temperatures, the thin film including the active dopants dissolves within the CdTe film, actively doping the grain boundaries of the CdTe film. In yet another embodiment the active dopants may be incorporated as impurities within the CdS film. Incorporating the active dopant in the CdS film can be accomplished by adding the active dopant species to the chemical bath solution out of which the CdS layer is deposited. The deposition could be accomplished either by chemical bath deposition or electrochemical deposition. On annealing and deposition at high temperatures, the dopants may leach out of the CdS film and occupy defect regions along the grain boundaries of the CdTe device.

In one embodiment, the diffusion may be achieved by exposing the layer to be doped to a reactive medium comprising the active dopant under controlled temperatures that assist in diffusion of the active dopant in the layer. In one embodiment, this reactive medium could be a plasma medium. The layer may be exposed to a plasma environment. Vapors containing the active dopant from gaseous, liquidus, or solidus precursors may be added to the plasma. The precursor may then dissociate to form various radicals, creating a highly 'chemical' reactive medium that will interact with the layer surface, allowing plasma chemistry at the surface, and resulting diffusion of the active dopants along the grain boundaries. Both low-energy or high-energy plasmas can be used, in which either electron collision or ion-plasma chemistry will result in precursor dissociation. A plasma is a highly reactive medium consisting of electrons and ions, and excited atoms or molecules, carrying enough energy for dissociation of precursors fed into the plasma.

As discussed above, in one embodiment, the layer wherein the active dopant concentration in the grain boundaries is sufficient to make the grain boundaries a type opposite to that of the type of the grains in the layer is an absorber layer. Again, as discussed above, in one embodiment, the active dopant concentration in the grain boundaries is sufficient to make the grain boundaries of the same type as the grains in the layer with the grain boundaries.

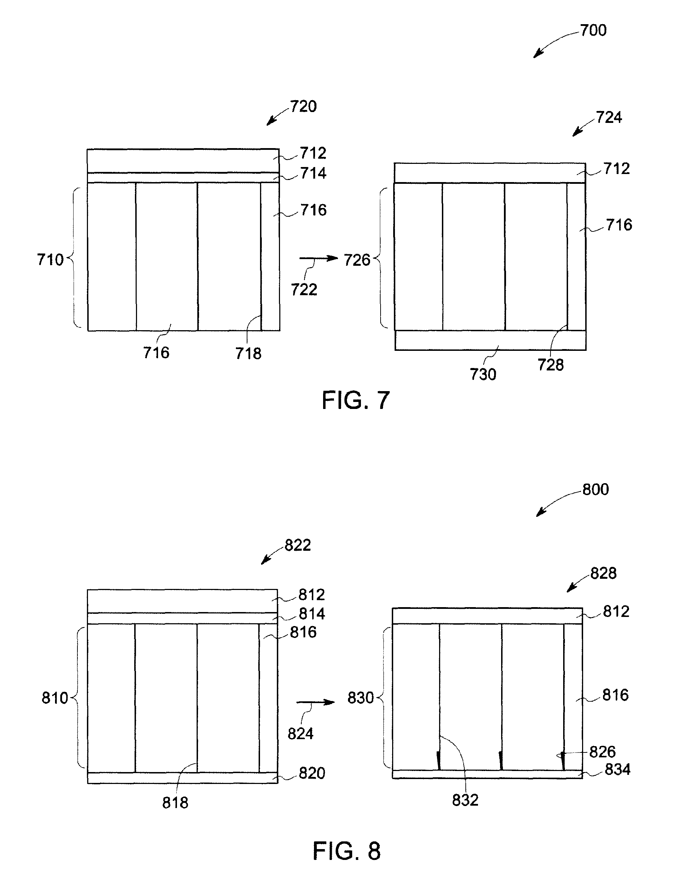

In FIG. 7 is provided a schematic 700 of a method to make a layer as shown in FIG. 2 in accordance with certain embodiments of the present invention. In one embodiment, an absorber layer 710, is formed by employing an ion-assisted physical vapor deposition technique. The absorber layer is deposited over a window layer 712. An active dopant layer 714 is deposited over the window layer 712 before the deposition of the absorber layer 710, i.e., the active dopant layer is sandwiched between the window layer 712 and the absorber layer 710. The absorber layer comprises grains 716 and grain boundaries 718. The grain boundaries 718 of the absorber layer 710 are substantially perpendicular to the window layer 712. The grains are p-type. The resultant layer 720 including the window layer 712, the active dopant layer 714, and the absorber layer 710, is then annealed 722 to drive the active dopant into the grain boundaries 718 resulting in a modified layer 724. The modified layer comprises a modified absorber layer 726 comprising p-type grains 716 and n-type grain boundaries 728. In one embodiment, the absorber layer 710 comprises CdTe. In one embodiment, the active dopant layer 714 comprises a thin metallic film containing the active dopant. A back contact layer 730 is disposed on one side of the absorber layer.

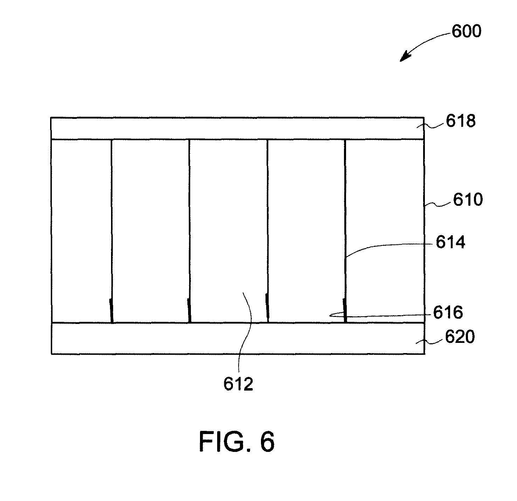

Referring to FIG. 8 a schematic 800 of a method to make a layer as shown in FIG. 6 in accordance with certain embodiments of the present invention is illustrated. In one embodiment, an absorber layer 810 is formed by employing an ion-assisted physical vapor deposition technique. The absorber layer is deposited over a window layer 812. An active dopant layer 814 is deposited over the window layer 812 before the deposition of the absorber layer, i.e., the active dopant layer is sandwiched between the window layer and the absorber layer 810. The absorber layer comprises grains 816 and grain boundaries 818. The grain boundaries 818 of the absorber layer 810 are substantially perpendicular to the window layer 812. The grains are p-type. A p-type layer 820 is disposed on the other side of the absorber layer 810. The resultant layer 822 including the window layer 812, the active dopant layer 814, the absorber layer 810, and the p-type layer 820 is then annealed 824 to drive the active dopant into the grain boundaries 818 and the p-type material into the bottom region of the grain boundaries 826 resulting in a modified layer 828. The modified layer comprises a modified absorber layer 830 comprising p-type grains 816 and n-type grain boundaries 832 with the amount of the active dopant in the grain boundaries near the bottom region of the layer sufficient to render the bottom region 826 of the grain boundaries p-type while simultaneously having a higher active dopant concentration when compared to the effective dopant concentration in the grains 816 of the absorber layer 810. In one embodiment, the absorber layer 810 comprises CdTe. In one embodiment, the active dopant layer 814 comprises a thin metallic film containing the active dopant. In one embodiment, the p-type layer 820 comprises copper.. A back contact layer 834 is disposed on one side of the absorber layer.

Typically, the efficiency of a solar cell is defined as the electrical power that can be extracted from a module divided by the power density of the solar energy incident on the cell surface. Using Figure 1 as a reference, the incident light 120 passes through the substrate 110, front contact layer 112, and window layer 114 before it is absorbed in the absorber layer 116, where the conversion of the light energy to electrical energy takes place via the creation of electron-hole pairs. There are four key performance metrics for photovoltaic devices: (1) Short-circuit current density ($J_{SC}$) is the current density at zero applied voltage (2) Open circuit voltage ($V_{OC}$) is the potential between the anode and cathode with no current flowing. At $V_{OC}$ all the electrons and holes recombine within the device. This sets an upper limit for the work that can be extracted from a single electron-hole pair. (3) Fill factor (FF) equals the ratio between the maximum power that can be extracted in operation and the maximum possible for the cell under evaluation based on its $J_{SC}$ and $V_{OC}$. Energy conversion efficiency (η) depends upon both the optical transmission efficiency and the electrical conversion efficiency of the device, and is defined as:

$$\eta = J_{SC} \, V_{OC} \, FF/P_S$$

with (4) $P_S$ being the incident solar power. The relationship shown in the equation does an excellent job of determining the performance of a solar cell. However, the three terms in the numerator are not totally independent factors and typically, specific improvements in the device processing, materials, or design may impact all three factors.

The short-circuit current depends on reflection losses, absorption losses in the glass, TCO and the CdS window layers, and the depletion depth of the electric field into the CdTe absorber layer. The minority carrier lifetime, in the case of p-type CdTe electrons, in CdTe is too short to allow a large contribution from the quasi-neutral region of the device and typically only electrons generated within the depletion depth contribute to the photocurrent. Typical depletion depths into the CdTe layer are of the order of about 0.5 micrometer to about 2 micrometer, depending on the effective carrier concentration of the CdTe layer. Charge generated outside this region typically does not contribute to the photocurrent. The open-circuit voltage is determined mainly by the effective carrier concentration of the CdTe layer. As CdTe is a heavily self-compensating material, the p-type carrier concentration of this layer is typically in the range from about $1 \times 10^{14}$ to about $3 \times 10^{14}$ per cubic centimeter, allowing a maximum open-circuit voltage of about 0.85 Volts, whereas the theoretical limit for materials with a bandgap in the 1.45 electron Volts range is slightly above 1 Volt. One skilled in the art will appreciate that the theoretical limit will depend on the carrier concentration. The fill factor for small area CdTe devices is mainly determined by the in-cell series and shunt resistance contributions; the Schottky barrier on the backside of these types of cells, attributable to the disparity between the work functions of the CdTe and the metal materials, can have a large contribution. This Schottky barrier arises from the fact that the electron affinity for CdTe is reported to be somewhere between 4.0 and 4.3 electron volts. As CdTe is a p-type material in most cell designs, this would result in a work function in a range of about 5.0 to about 5.4 electron Volts, depending on the exact position of the Fermi-level. As not many metals have work functions that high, this may typically result in a Schottky barrier.

As discussed above the CdTe layer comprises grains and grain boundaries. In conventional devices, the grains are generally p-type and the grain boundary is thin and lightly doped, and thus mostly depleted by the p-charge in the grains. The defects in the grain boundaries result in decreased current extraction from the cell because there are disconnects generated at the grain boundaries. In some embodiments, the 'standard' Cadmium Chloride ($CdCl_2$-) treatment may be omitted from the process, as that treatment may result in an undesired re-crystallization of the layer and thus disturb the structure of the columnar grains. In certain embodiments, a controlled $CdCl_2$-treatment (or other Chlorine containing treatments) may be provided such that the columnar grain structure is obtained. Also, since the as-deposited material may often have lower carrier density due to the heavy self-compensating effects in CdTe, a post-treatment may be necessary for device improvement. Typi-

cally, the $CdCl_2$-treatment improves the effective carrier density of the CdTe film to p-type at a density of $2 \times 10^{14}$ to $3 \times 10^{14}$ per cubic centimeter, which leads to a maximum open-circuit voltage of about 850 milli Volts, well below the theoretical limit of about 1050 milli Volts for a material with a bandgap in the range of 1.45-1.50 electron Volts. Thus the improvement in carrier density due to the Cl-treatment has long been acknowledged as a critical step in CdTe device preparation and is thus incorporated in typical processing. However, the $CdCl_2$-treatment step is also the efficiency limiting step. The treatment results in the creating of Cd-vacancies, which renders the CdTe layer p-type. The treatment also results in the formation of Cd interstitials, which results in a self-compensating effect that keeps the effective carrier density in the CdTe layer below $5 \times 10^{14}$ per cubic centimeter. The CdTe material as-deposited material is highly multi-crystalline, wherein the low-defect density grains are surrounded by high-defect density grain boundaries, resulting in very highly self-compensating material. In the as-deposited layer the p-type grains are surrounded by both n-and p-type defects in the grain boundary. Typically $CdCl_2$-treatment is employed as a flux for re-crystallization and decreasing the amount of self-compensating defects and increasing the amount of Cd-vacancies. In certain embodiments, as discussed herein, active dopants may be employed to passivate the defects along the grain boundaries.

The devices known in the art have layers that often are treated in performance modeling as single crystal layers, though the layers are multi-crystalline. The layers include grains interspaced with grain boundaries. The devices, however, comprise defects in the grain boundaries that compensate for the doping concentration in the grains, resulting in a relatively low effective doping concentration in the range of $1 \times 10^{14}$ to $3 \times 10^{14}$ per cubic centimeter.

Typically, the grain boundary is thin and lightly doped, and thus mostly depleted of charge carriers by the p-charge in the grains. The depletion of charge carriers may be explained as follows. When two semiconductors are placed together, they may interact and electric fields may extend into each other. This extension of the electric fields largely depends on the doping concentration of the material. The extension may be about 1 micron for $10^{15}$ cubic centimeter charge concentration and maybe about 5 nanometers for $10^{19}$ cubic centimeter charge concentration. Thus grain boundaries could be completely depleted of charge if not doped to a very high level. If the grain boundary is doped to varying levels all through the grain boundary, then the electric field strength in the grain boundary may be different from location to location. When the grain boundaries are not actively doped, but rely on doping through defects, the grain boundaries will have different doping concentration at different locations within the grain boundaries. This may result in some regions being slightly n-type and some regions being slightly p-type and thus result in certain locations actually acting as transport barriers. By actively over-doping the grain boundaries, this effect of barriers may be reduced. For example, an electron traveling through the grain boundary will experience significant resistance. However if the grain boundary is appropriately doped with a charge carrier of the type opposite to the type of the charge in the grains then it may be easier for the electron to pass through.

Typically, as discussed above, CdTe films tend to have relatively weak pn-junctions resulting from the p type grains and the depleted grain boundaries. This leads to relatively low Voc. This may be improved by actively doping the grain boundaries such that the grains are p-type and the grain boundaries are n-type. Thus the active doping of the grain boundaries may assist in forming strong pn-junctions all through the device. The introduction of active dopants not only decreases or passivates the defects in the grain boundaries but also assists in improving the current extraction through the grain boundary interfaces. Thus higher Voc can be obtained for these types of devices. By actively doping the grain boundaries of the layers in the devices higher potential efficiencies can be achieved than currently achieved. For example, where appropriately doped CdTe grains in the range of $10^{17}$ cubic centimeter are considered, a relatively low Voc may be assigned for those devices based on a low effective doping level of the grain boundaries. Typically, there are two types of build-in voltages The Voc is typically determined by a horizontal build-in voltage between grains and grain boundaries and a vertical build-in voltage between say for example, the CdS window layer and the CdTe absorber layer, which results from the major p-n junction. The horizontal build-in voltage, which is dependent on the difference in Fermi level in the p-type versus the n-type material, helps to separate electron and holes horizontally. The vertical build-in voltage helps in carrier transportation, which ultimately defines the performance of the device in terms of Voc, Jsc and FF. Further it may also be advantageous to have the bottom region of the grain boundaries in the CdTe layer to be rendered p-type. By making the bottom region p-type a barrier may be formed for the electrons. When the grain boundaries are rendered n-type, the electrons may move to the grain boundaries. If the n-type grain boundaries are in direct contact with the back contact layer, the electrons could leak to the back contact, causing a significant leakage current, which will lower the Voc. By adding p-type dopants in the grain boundary near the bottom, electrons may not move to the bottom regions of the grain boundaries. Further, rendering the grain boundaries in the bottom more p-type than the grains may assist in hole-collection.

Typically, for CdTe devices (that is, where CdTe is included in the absorber layer), CdS is employed as an adjacent n-type layer. If the CdS layer is doped at $10^{17}$ per cubic centimeter and the CdTe is p-type doped at $2 \times 10^{14}$ per cubic centimeter, the theoretical $V_{OC}$ of such a device may be calculated to be about 850 milli Volts, while the theoretical limit based on the bandgap for CdTe is about 1040 milli Volts. As mentioned above, one skilled in the art will appreciate that the theoretical limit depends on the carrier concentration. On the other hand, if the junction is now between the grain boundary and the grain within the CdTe layer, and not between the CdS and the CdTe, the view may differ. The relatively low Voc value is now attributed to the difference between the $10^{17}$ per cubic centimeter p-type grains versus $10^{15}$ per cubic centimeter n-type grain boundaries. Hence, if the doping content of the grain boundaries is increased it can result in an increased Voc.

While only certain features of the invention have been illustrated and described herein, many modifications and changes will occur to those skilled in the art. It is, therefore, to be understood that the appended claims are intended to cover all such modifications and changes as fall within the true spirit of the invention.

Various aspects and embodiments of the present invention are defined by the following numbered clauses:

1. A photovoltaic device, comprising:

an absorber layer, wherein the absorber layer comprises a plurality of grains separated by grain boundaries;
wherein at least one layer is disposed over the absorber layer;
wherein the absorber layer comprises grain boundaries that are substantially perpendicular to the at least one layer disposed over the absorber layer; and
wherein the plurality of grains has a median grain diameter of less than 1 micrometer.

2. The photovoltaic device of clause 1, wherein the grains are columnar.

3. The photovoltaic device as defined in any preceding clause, wherein the absorber layer comprises cadmium telluride, cadmium zinc telluride, tellurium-rich cadmium telluride, cadmium sulfur telluride, cadmium manganese telluride, or cadmium magnesium telluride.

4. The photovoltaic device of any preceding clause, wherein the layer is a window layer.

5. The photovoltaic device as defined in any preceding clause, wherein the window layer comprises cadmium sulfide, zinc telluride, zinc selenide, cadmium selenide, cadmium sulfur oxide, and or copper oxide.

6. The photovoltaic device as defined in any preceding clause, wherein the layer is a back contact layer.

7. The photovoltaic device as defined in any preceding clause, wherein the back contact layer comprises zinc telluride, mercury telluride, cadmium mercury telluride, arsenic telluride, antimony telluride, and copper telluride.

8. The photovoltaic device as defined in any preceding clause, wherein the grain boundaries comprise an active dopant.

9. The photovoltaic device as defined in any preceding clause, wherein the active dopant density in the grain boundaries is sufficient to make the grain boundaries a type opposite to the type of the grains.

10. The photovoltaic device as defined in any preceding clause, wherein the grains are a p-type semiconductor and the grain boundaries are an n-type semiconductor.

11. The photovoltaic device as defined in any preceding clause, wherein the grains are an n-type semiconductor and the grain boundaries are a p-type semiconductor.

12. The photovoltaic device as defined in any preceding clause, wherein the active dopant density in the grain boundaries is sufficient to make the grain boundaries of the same type as the type of the grains.

13. The photovoltaic device as defined in any preceding clause, wherein the grains are a p-type semiconductor and the grain boundaries are a p-type semiconductor.

14. The photovoltaic device as defined in any preceding clause, wherein the grains are an n-type semiconductor and the grain boundaries are an n-type semiconductor.

15. The photovoltaic device as defined in any preceding clause, wherein the active dopant comprises a material selected from aluminum, gallium, indium, iodine, chlorine, and bromine.

16. The photovoltaic device as defined in any preceding clause, wherein the active dopant comprises a material selected from copper, gold, silver, sodium, bismuth, sulfur, arsenic, phosphorous, and nitrogen.

17. The photovoltaic device as defined in any preceding clause, wherein the grain boundaries have a higher active dopant concentration when compared to an effective dopant concentration in the grains.

18. The photovoltaic device as defined in any preceding clause, wherein the active dopant concentration in the grain boundaries is in a range from about $5 \times 10^{16}$ per cubic centimeter to about $10^{19}$ per cubic centimeter.

19. The photovoltaic device as defined in any preceding clause, wherein the effective dopant concentration in the grains is in a range from about $10^{16}$ per cubic centimeter to about $10^{18}$ per cubic centimeter.

20. A photovoltaic device, comprising:

an absorber layer, wherein the absorber layer comprises a plurality of grains separated by grain boundaries;
wherein at least one layer is disposed over the absorber layer;
wherein the absorber layer comprises grain boundaries that are substantially perpendicular to the layer;
wherein the grain boundaries comprise an active dopant; and
wherein the active dopant concentration in the grain boundaries is higher than the effective dopant concentration in the grains.

21. The photovoltaic device as defined in any preceding clause, wherein the layer is a window layer.

22. The photovoltaic device as defined in any preceding clause, wherein the layer is a back contact layer.

23. The photovoltaic device as defined in any preceding clause, wherein the active dopant density in the grain boundaries is sufficient to make the grain boundaries a type opposite to that of the type of the grains in the layer.

24. The photovoltaic device as defined in any preceding clause, wherein the amount of the active dopant in the grain boundaries is sufficient to make the grain boundaries of the same type as the grains in the layer with the grain boundaries.

25. The photovoltaic device as defined in any preceding clause, wherein the active dopant comprises a material selected from aluminum, gallium indium, iodine, chlorine, and bromine.

26. The photovoltaic device as defined in any preceding clause, wherein the active dopant comprises a material selected from copper, gold, silver, sodium, bismuth, sulfur, arsenic, phosphorous, and nitrogen.

27. The photovoltaic device as defined in any preceding clause, wherein active dopant concentration in the grain boundaries is in a range from about $5 \times 10^{16}$ per cubic centimeter to about $10^{19}$ per cubic centimeter.

28. The photovoltaic device as defined in any preceding clause, wherein effective dopant concentration in the grains is in a range from about $10^{16}$ per cubic centimeter to about $10^{18}$ per cubic centimeter.

29. The photovoltaic device as defined in any preceding clause, wherein the plurality of grains has a median grain diameter of less than 1 micrometer.

30. A photovoltaic device, comprising:

an absorber layer, wherein the absorber layer comprises a plurality of grains separated by grain boundaries;
wherein at least one layer is disposed over the absorber layer;
wherein the absorber layer comprises grain boundaries that are substantially perpendicular to the layer;
wherein the grain boundaries comprise an active dopant; and
wherein the amount of the active dopant in the grain boundaries is sufficient to make the grain boundaries a type opposite to that of the type of the grains in the layer; and
wherein the amount of the active dopant in the grain boundaries near the bottom region of the layer is sufficient to allow the grain boundaries in the bottom region to remain of a type similar to the type of the grains while simultaneously having a higher active dopant concentration in the grain boundaries when compared to the effective dopant concentration in the grains.

31. A method comprising:

providing an absorber layer in a photovoltaic device, wherein the absorber layer comprises a plurality of grains separated by grain boundaries, wherein at least one layer is disposed over the absorber layer,
wherein the absorber layer comprises grain boundaries that are substantially perpendicular to the layer, and wherein the plurality of grains has a median grain diameter of less than 1 micrometer.

32. The method as defined in clause 31, wherein the grains are deposited using one or more techniques selected from close-space sublimation, vapor transport deposition, ion-assisted physical vapor deposition, radio frequency or pulsed magnetron sputtering, and electrochemical bath deposition.

33. A method comprising:

providing an absorber layer in a photovoltaic device, wherein the absorber layer comprises a plurality of grains separated by grain boundaries, wherein at least one layer is disposed over the absorber layer, wherein the absorber layer comprises grain boundaries that are substantially perpendicular to the layer;
wherein the grain boundaries comprise an active dopant; and
wherein the active dopant concentration in the grain boundaries is higher than the effective dopant concentration in the grains.

34. The method as defined in any of clauses 31 to 33, wherein providing the absorber layer comprises:

providing an active dopant; and
treating the at least one layer in a manner such that the active dopant is diffused into the grain boundaries.

35. The method as defined in any of clauses 31 to 34, wherein the grains are deposited using one or more techniques selected from close-space sublimation, vapor transport deposition, ion-assisted physical vapor deposition, radio frequency or pulsed magnetron sputtering, and electrochemical bath deposition.

**Claims**

1. A photovoltaic device (100), comprising:

an absorber layer (416), wherein the absorber layer comprises a plurality of grains (412) separated by grain boundaries;
wherein at least one layer is disposed over the absorber layer;
wherein the absorber layer (416) comprises grain boundaries that are substantially perpendicular to the at least one layer disposed over the absorber layer; and
wherein the plurality of grains (412) has a median grain diameter of less than 1 micrometer.

2. The photovoltaic device (100) of claim 1, wherein the grains (412) are columnar.

3. The photovoltaic device (100) of any preceding claim, wherein the layer is a window layer.

4. The photovoltaic device (100) as defined in any preceding claim, wherein the layer is a back contact layer.

5. The photovoltaic device (100) as defined in any preceding claim, wherein the grain boundaries comprise an active dopant.

**6.** A photovoltaic device (100), comprising:

an absorber layer (416), wherein the absorber layer comprises a plurality of grains (412) separated by grain boundaries;

wherein at least one layer is disposed over the absorber layer;

wherein the absorber layer (416) comprises grain boundaries that are substantially perpendicular to the at least one layer disposed over the absorber layer;

wherein the grain boundaries comprise an active dopant; and

wherein the active dopant concentration in the grain boundaries is higher than the effective dopant concentration in the grains.

**7.** A photovoltaic device (100), comprising:

an absorber layer (416), wherein the absorber layer comprises a plurality of grains (412) separated by grain boundaries;

wherein at least one layer is disposed over the absorber layer;

wherein the absorber layer comprises grain boundaries that are substantially perpendicular to the at least one layer disposed over the absorber layer;

wherein the grain boundaries comprise an active dopant; and

wherein the amount of the active dopant in the grain boundaries is sufficient to make the grain boundaries a type opposite to that of the type of the grains in the layer; and

wherein the amount of the active dopant in the grain boundaries near the bottom region of the layer is sufficient to allow the grain boundaries in the bottom region to remain of a type similar to the type of the grains while simultaneously having a higher active dopant concentration in the grain boundaries when compared to the effective dopant concentration in the grains.

**8.** A method comprising:

providing an absorber layer (416) in a photovoltaic device (100), wherein the absorber layer comprises a plurality of grains (412) separated by grain boundaries, wherein at least one layer is disposed over the absorber layer,

wherein the absorber layer comprises grain boundaries that are substantially perpendicular to the at least one layer disposed over the absorber layer (416), and wherein the plurality of grains (412) has a median grain diameter of less than 1 micrometer.

**9.** A method comprising:

providing an absorber layer (416) in a photovoltaic device (100), wherein the absorber layer comprises a plurality of grains (412) separated by grain boundaries, wherein at least one layer is disposed over the absorber layer, wherein the absorber layer comprises grain boundaries that are substantially perpendicular to the at least one layer disposed over the absorber layer;

wherein the grain boundaries comprise an active dopant; and

wherein the active dopant concentration in the grain boundaries is higher than the effective dopant concentration in the grains.

**10.** The method as defined in claim 9, wherein providing the absorber layer (416) comprises:

providing an active dopant; and

treating the at least one layer in a manner such that the active dopant is diffused into the grain boundaries.

FIG. 1

FIG. 2

FIG. 3

FIG. 4

FIG. 5

600

618

610

614

616

620

612

FIG. 6

FIG. 7

FIG. 8